# EUROPÄISCHE PATENTSCHRIFT

(11) **EP 3 140 864 B1**
(45) Veröffentlichungstag und Bekanntmachung des Hinweises auf die Patenterteilung: **06.11.2019**
(21) Anmeldenummer: 14736376.6
(22) Anmeldetag: 03.07.2014
(51) Int. Cl.: H01L 25/11, H01L 25/07

(54) **SPANNVERBAND MIT FEDEREINRICHTUNG**
CLAMPING ASSEMBLY HAVING A SPRING SYSTEM
ATTACHE DE SERRAGE COMPORTANT UN DISPOSITIF RESSORT

(43) Veröffentlichungstag der Anmeldung: 15.03.2017
(73) Patentinhaber: Siemens Aktiengesellschaft, 80333 München (DE)
(72) Erfinder: BÖHM, Matthias, 91564 Neuendettelsau (DE); BREHM, Holger Siegmund, 91052 Erlangen (DE); SCHMITT, Daniel, 90459 Nürnberg (DE)
(86) Internationale Anmeldenummer: PCT/EP2014/064179
(87) Internationale Veröffentlichungsnummer: WO 2016/000775

(56) Entgegenhaltungen:
- WO-A1-2013/044409
- JP-A- S58 200 561
- US-A1- 2006 226 450

## Beschreibung

Die Erfindung betrifft einen Spannverband mit einer Anordnung mechanisch verspannter, stapelweise übereinander liegender Bauelemente mit einer Federeinrichtung sowie einer Spannvorrichtung zum Erzeugen mechanischer Druckkraft auf die Anordnung der Bauelemente.

Ein solcher Spannverband findet beispielsweise in der Hochspannungstechnik Anwendung. Dort werden insbesondere Halbleiter-Bauelemente miteinander verspannt, um eine möglichst gute elektrische Kontaktierung zwischen ihnen zu erreichen.

Die bekannten Spannverbände sind meist über mechanische Elemente verspannt, beispielsweise geeignete Gewindesysteme. Die Druckkraftübertragung auf die Anordnung der Bauelemente erfolgt meist punktuell mit einem oder mehreren Schraubelementen und wird dann über Druckstücke großflächig verteilt, so dass die Bauelemente im Spannverband verpresst werden.

Im Beitrag "4.5kV Press Pack IGBT Designed for Ruggedness and Reliability" von S. Eicher et al., IAS Seattle 2004, ist ein IGBT-Modul (ein sogenanntes Press Pack-Modul) mit parallel angeordneten IGBT-Chipeinheiten beschrieben, die in einem gemeinsamen Gehäuse aufgenommen sind. Das Gehäuse weist eine sich über mehrere Chipeinheiten erstreckende obere und eine untere leitende Platte auf, die die von einer gemeinsamen Spannvorrichtung erzeugte mechanische Kraft auf die Chipeinheiten überträgt. Jede Chipeinheit bildet eine Anordnung von stapelweise übereinander liegenden Bauelementen. Jeder der die Chipeinheit bildenden Anordnungen ist dabei eine einzelne Tellerfeder zugeordnet, so dass die Kraftübertragung auf die IGBT-Chips jeweils mittels der einzelnen Tellerfeder erfolgt. Die Druckverteilung auf den gepressten Flächen der einzelnen Chipeinheiten mittels der jeweiligen Tellerfeder ist allerdings relativ inhomogen.

Mit steigender Fläche der verpressten Bauelemente gewinnt die Homogenität der Verteilung der Druckkraft jedoch an Bedeutung. Werden zudem dünne und spröde Bauelemente, wie beispielsweise Halbleiter-Chips, verwendet, so ist eine homogene Verteilung der Druckkraft gar von entscheidender Bedeutung. Inhomogenitäten können in solchen Fällen zu einer Beschädigung und einem Ausfall der Bauelemente führen.

In der WO 2013/044409 A1 ist eine Spannvorrichtung offenbart, die eine Mehrzahl von Halbleiterschaltern mechanisch miteinander verspannt. Die mechanische Spannkraft wird mittels Tellerfedern übertragen, die an vier Spannstäben angeordnet sind, wobei die Spannstäbe sich zwischen jeweils zwei Druckplatten der Spannvorrichtung erstrecken.

Weitere Anwendungen von Federelementen in Halbleiterspannverbänden sind aus der JP S58 200561 A und der US 2006/226450 A1 bekannt.

Die Aufgabe der Erfindung ist es daher, einen Spannverband der obigen Art vorzuschlagen, bei dem die Übertragung der Druckkraft möglichst homogen ist.

Die Aufgabe wird erfindungsgemäß durch einen Spannverband gemäß dem Patentanspruch 1 gelöst.

Die miteinander verbundenen Tellerfederelemente der erfindungsgemäßen Anordnung übertragen die durch die Spannvorrichtung ausgeübte Druckkraft auf die Bauelemente der Anordnung derart, dass sich die Druckkraft relativ homogen über die gesamte der Federplatte zugewandte Oberfläche der Bauelemente der Anordnung verteilt. Dieser Effekt ist insbesondere von der Flächenausdehnung der Oberfläche der Bauelemente unabhängig, weil die Federplatte dementsprechend erweiterbar ist, wobei auch die Anzahl der Tellerfederelemente mit der Flächenausdehnung skaliert werden kann.

Geeigneterweise sind die Tellerfederelemente als kegelige Ringschalen geformt, die einen oberen Innenrand sowie einen unteren Außenrand aufweisen, wobei die Krafteinleitung entlang der Symmetrieachse der Ringschale erfolgt. Die Tellerfederelemente sind geeigneterweise am unteren Außenrand miteinander verbunden.

Gemäß einer bevorzugten Ausführungsform der Erfindung umfasst der Spannverband ein Druckstück zum Übertragen der mechanischen Druckkraft von der Spannvorrichtung auf die Anordnung der Bauelemente. Die Federplatte ist zwischen dem Druckstück und den Bauelementen angeordnet. Es ist dabei von Vorteil, wenn die Federplatte mit den oberen Innenrändern der Tellerfederelemente zum Druckstück hin weist. Über das geeignet geformte Druckstück, wobei das Druckstück beispielsweise eine Kegel- oder Trapezform haben kann, ist die Druckkraft von der Spannvorrichtung auf die Bauelemente besonders flächig homogen übertragbar. Geeigneterweise ist die Grundfläche des Druckstücks an die Geometrie der Anordnung angepasst

Erfindungsgemäß weisen die Tellerfederelemente unterschiedliche Federcharakteristiken auf. Die unterschiedlichen Federcharakteristiken der Tellerfederelemente machen eine besonders gute Anpassung der Druckkraftübertragung an die jeweilige Anforderung möglich.

Besonders vorteilhaft ist es, wenn wenigstens eines der Tellerfederelemente eine degressive Federcharakteristik aufweist. Bei einer degressiven Federcharakteristik verhält sich die Stauchung des Tellerfederelementes überproportional zu einer auf das Tellerfederelement wirkenden Kraft.

Gemäß einer bevorzugten Ausführungsform der Erfindung umfasst die Anordnung eine weitere Federplatte, die zwischen zwei Bauelementen angeordnet ist. Durch die Verwendung der weiteren Federplatte ist eine weitere Verbesserung der Homogenität der Druckkraftübertragung erreichbar. Es ist selbstverständlich denkbar, darüber hinaus noch Federplatten im Spannverband vorzusehen.

Einige der Bauelemente können beispielsweise elektrische Bauelemente sein, wobei über die verpressten Oberflächen der elektrischen Bauelemente ein elektrischer Kontakt zwischen ihnen hergestellt ist.

Gemäß einer vorteilhaften Ausführungsform der Erfindung umfasst die Anordnung ein Halbleiterelement, wobei das Halbleiterelement parallel angeordnete Press-Pack-Halbleiter umfasst. Damit setzt sich das Halbleiterelement aus nebeneinander angeordneten Halbleitermodulen zusammen. Die Halbleitermodule bilden eine Parallelschaltung von elektrischen Bauteilen. Beispielsweise kann es sich dabei um IGBT-Halbleiter, Dioden oder Thyristorelemente handeln. Die Oberfläche solcher Halbleitermodule kann beispielsweise einen Durchmesser von 6 bis 9 mm aufweisen. Die zu verpressende Oberfläche der Bauteile kann zwischen 400 und 1000 cm² betragen.

Zur Kühlung des Halbleiterelementes umfasst die Anordnung ferner vorteilhaft wenigstens eine Kühlplatte aus leitfähigem Material, wobei die wenigstens eine Kühlplatte am Halbleiterelement anliegend angeordnet ist, so dass ein elektrischer Kontakt zwischen dem Halbleiterelement und der Kühlplatte besteht. Die Kühlplatte dient zur Ableitung der im Halbleiterelement entstehenden Wärme. Diese Wärme entsteht insbesondere durch den Durchlasswiderstand des Halbleiterelementes. Geeigneterweise besteht die Kühlplatte aus einem wärmeleitenden, bevorzugt gut Wärme leitendem Material, wie beispielsweise Metall oder einer Metalllegierung.

Die Anordnung kann auch mehrere Halbleiterelemente umfassen, wobei jedem der Halbleiterelemente wenigstens eine Kühlplatte zugeordnet ist und die Halbleiterelemente eine elektrische Reihenschaltung ausbilden.

Besonders bevorzugt ist es, wenn jedem Halbleiterelement zwei Kühlplatten zugeordnet sind, die beidseitig des Halbleiterelementes angeordnet sind. Auf diese Weise kann die Wärmeabfuhr zu beiden Seiten des Halbleiterelementes erfolgen. Da die Kühlplatten aus leitfähigem Material hergestellt sind, kann die elektrische Kontaktierung zwischen den Halbleiterelementen mittels der Kühlplatten hergestellt werden. Zur Verbesserung der Druckkraftübertragung auf die Halbleiterelemente kann die Anordnung eine zusätzliche Federplatte umfassen, die zwischen zwei Kühlplatten angeordnet ist.

Besonders bevorzugt ist es, ein Gegendruckstück vorzusehen, das dem Druckstück gegenüberliegend angeordnet ist, wobei eine ergänzende Federplatte zwischen dem Gegendruckstück und den Bauelementen angeordnet ist. Die ergänzende Federplatte kann dabei derart angeordnet sein, dass die Tellerfederelemente der ergänzenden Federplatte zu der Federplatte gegensinnig orientiert sind.

Ferner betrifft die Erfindung ein Submodul eines Umrichters mit wenigstens einer Reihenschaltung von Leistungshalbleiterschalteinheiten, die jeweils einen ein- und abschaltbaren Leistungshalbleiter mit gleicher Durchlassrichtung aufweisen und jeweils entgegen der besagten Durchlassrichtung leitfähig sind und einem dazu in einer Parallelschaltung angeordneten Energiespeicher. Ein solches Submodul ist beispielsweise aus der DE 101 030 31 A1 bekannt.

Ausgehend von dem bekannten Submodul ist eine weitere Aufgabe der Erfindung, ein Submodul der vorstehend genannten Art vorzuschlagen, das möglichst wenig fehleranfällig ist.

Die Aufgabe wird erfindungsgemäß durch ein artgemäßes Submodul gelöst, bei dem die Reihenschaltung der Leistungshalbleiterschalteinheiten in einer zuvor beschriebenen Spannvorrichtung realisiert ist. Durch die Verpressung der Leistungshalbleiterschalteinheiten mittels der Federplatte kann das Risiko einer Beschädigung und damit eines Fehlers der Halbleiter infolge inhomogener Druckverteilung vermindert werden.

Die Erfindung wird nachfolgend anhand der in Figuren 1 - 5 dargestellten Ausführungsbeispiele näher erläutert.
- Figur 1: zeigt ein Ausführungsbeispiel eines erfindungsgemäßen Spannverbandes im seitlichen Querschnitt und in einer schematischen Darstellung.
- Figur 2: zeigt eine perspektivische Ansicht einer Federplatte des Spannverbandes der Figur 1.
- Figur 3: zeigt eine Seitenansicht eines Tellerfederelementes 31 der Figuren 1 und 2 in schematischer Darstellung.
- Figur 4: zeigt eine Seitenansicht des Tellerfederelementes 31 der Figuren 1 bis 3 in einer belasteten Stellung.
- Figur 5: zeigt ein Ausführungsbeispiel eines erfindungsgemäßen Submoduls in schematischer Darstellung.

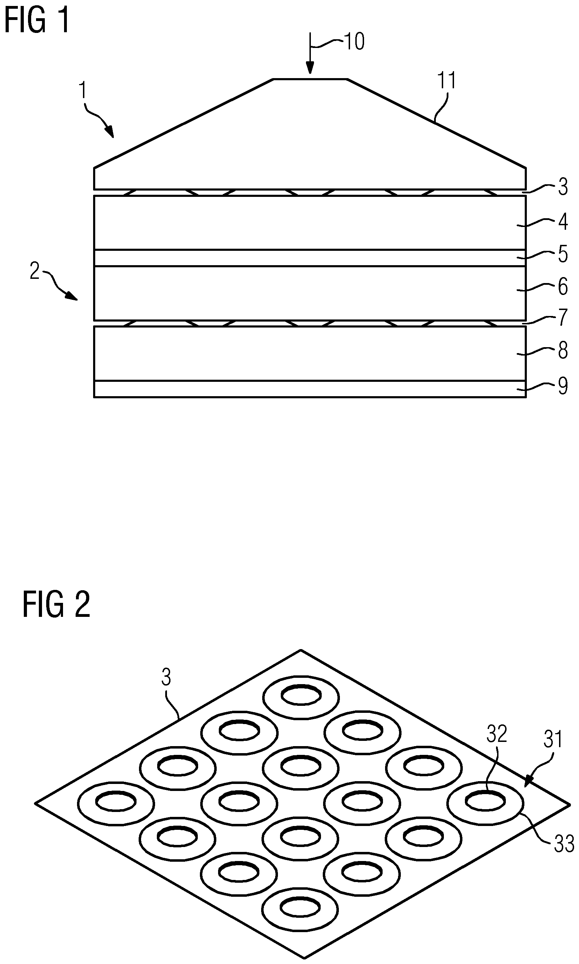

Im Einzelnen ist in Figur 1 ein Ausführungsbeispiel eines erfindungsgemäßen Spannverbandes dargestellt. Der Spannverband 1 umfasst eine Anordnung 2 von Bauelementen 3, 4, 5, 6, 7, 8 und 9. Die Bauelemente 3 - 9 sind stapelweise übereinander angeordnet. Dabei bilden die Bauelemente 3 - 9 eine säulenartige Anordnung 2. Die Anordnung 2 der Bauelementen wird mittels einer in Figur 1 nicht grafisch dargestellten Spannvorrichtung mechanisch verspannt, wobei auf die Anordnung 2 eine Druckkraft wirkt, die mittels des Pfeils 10 in Figur 1 gekennzeichnet ist. Die Druckkraft im in Figur 1 gezeigten Ausführungsbeispiel kann 10-12 t^{∗}g betragen. Ein trapezartiges Druckstück 11 überträgt die Kraft von der Spannvorrichtung auf die Anordnung. Im Einzelnen umfasst die Anordnung eine erste Federplatte 3, eine erste Kühlplatte 4, ein erstes Halbleiterelement 5, eine zweite Kühlplatte 6, eine zweite Federplatte 7, eine dritte Kühlplatte 8 sowie ein zweites Halbleiterelement 9. Ferner umfasst die Anordnung 2 weitere Bauelemente, die in Figur 1 unterhalb des zweiten Halbleiterelementes 9 angeordnet, jedoch in Figur 1 nicht grafisch dargestellt sind. Auch die mechanische Verspannung der gesamten Anordnung 2, die mittels eines Gegendruckstücks realisiert ist, ist in Figur 1 nicht grafisch dargestellt. Es ist jedoch im vorliegenden Beispiel vorgesehen, den Spannverband spiegelbildlich zur dargestellten oberen Hälfte der Anordnung 2 entsprechend auszugestalten.

In Figur 2 ist eine perspektivische Ansicht der Federplatte 3 der Figur 1 dargestellt. Gemäß dem in Figur 1 dargestellten Ausführungsbeispiel des Spannverbandes 1 sind die Federplatten 3 und 7 gleichartig ausgebildet. Die Federplatte 3 weist sechzehn Tellerfederelemente 31 auf, wobei die Tellerfederelemente 31 gemäß dem in Figur 2 dargestellten Ausführungsbeispiel alle gleichartig aufgebaut sind. Jedes der Tellerfederelemente 31 weist einen oberen Innenrand 32 sowie einen unteren Außenrand 33 auf. Die Tellerfederelemente 31 sind an ihren unteren Außenrändern 33 miteinander verbunden, so dass sie die Federplatte 3 bilden. In dem in Figur 2 dargestellten Ausführungsbeispiel ist die Grundfläche der Federplatte quadratisch. Es ist jedoch sinnvoll, die Grundfläche an die Grundfläche der Anordnung 2 anzupassen. Diese kann beispielsweise auch rechteckig oder kreisförmig sein. Die Tellerfederelemente 31 der Federplatte 3 weisen unterschiedliche Federcharakteristiken auf, falls es für die Anwendung des Spannverbandes 1 sinnvoll ist. Beispielsweise haben die zwölf Tellerfederelemente 31 am Rand der Federplatte 3 eine andere Federcharakteristik als die vier übrigen Tellerfederelemente 31.

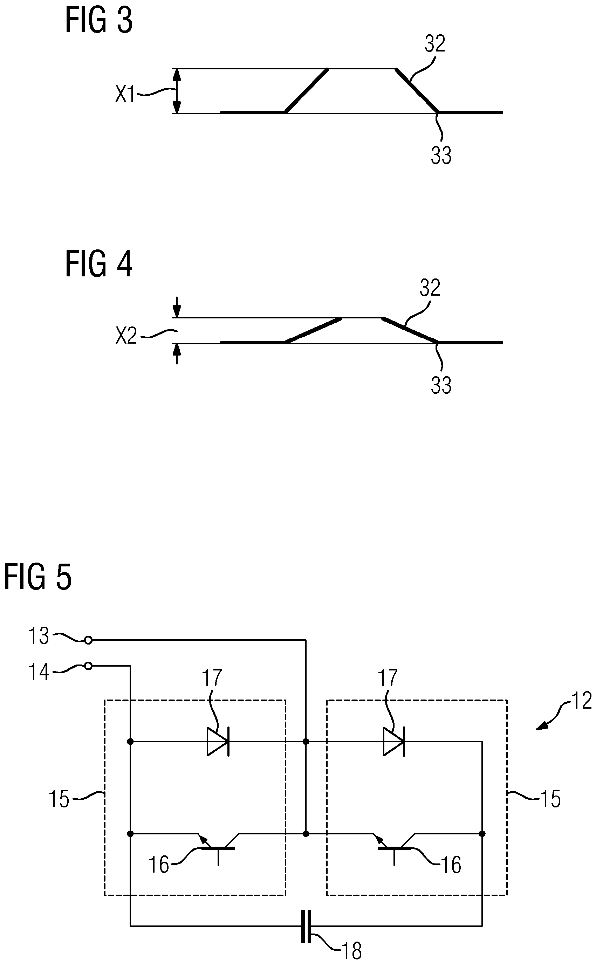

Das Verhalten eines der Tellerfederelemente 31 bei Kraftbelastung ist in den Figuren 3 und 4 näher erläutert.

Figur 3 zeigt das Tellerfederelement 31 in einem unbelasteten Zustand, das heißt, wenn keine Kraft von der Spannvorrichtung auf die Federplatte 3 übertragen wird. Der Abstand zwischen dem unteren Außenrand 33 und dem oberen Innenrand 32 des Tellerfederelementes 31 ist in diesem unbelasteten Zustand in Figur 3 mit x1 gekennzeichnet.

In Figur 4 ist erkennbar, dass in einem belasteten Zustand sich der Abstand zwischen dem oberen Innenrand 32 und dem unteren Außenrand 33 verringert. Der verkleinerte Abstand ist in Figur 4 mit x2 gekennzeichnet. Die Abhängigkeit der Differenz der Abstände x1-x2 von der belastenden Druckkraft auf das Tellerfederelement 31 wird als Federcharakteristik bezeichnet.

In Figur 5 ist ein Ausführungsbeispiel eines erfindungsgemäßen Submoduls 12 dargestellt. Das Submodul 12 ist zweipolig ausgebildet, wobei die Pole oder Klemmen des Submoduls 12 in Figur 5 mit den Bezugszeichen 13 und 14 gekennzeichnet sind. Das Submodul 12 bildet einen Teil eines nicht grafisch dargestellten Umrichters, wobei eine Mehrzahl von Submodulen, die zum Submodul 12 gleichartig aufgebaut sind, in Reihe geschaltet sind. Das Submodul 12 weist eine Reihenschaltung von Leistungshalbleiterschalteinheiten 15 auf, wobei jede der beiden Leistungshalbleiterschalteinheiten 15 einen Leistungshalbleiterschalter 16, der sowohl ein- als auch abschaltbar ist, und eine dazu gegensinnig parallel geschaltete Diode 17 umfasst. Das Submodul 12 umfasst ferner einen Speicherkondensator 18, der parallel zu der Reihenschaltung der Leistungshalbleiterschalter 15 angeordnet ist. Die Reihenschaltung der Leistungshalbleiterschalteinheiten 15 ist in Form eines in den Figuren 1 bis 4 dargestellten Spannverbandes 1 aufgebaut.

### Bezugszeichenliste

- 1: Spannverband
- 2: Anordnung
- 3: Federplatte
- 4, 6, 8: Kühlplatte
- 5,9: Halbleiterelement
- 10: Pfeil
- 11: Druckstück
- 12: Submodul
- 13, 14: Klemme
- 15: Leistungshalbleiterschalteinheit
- 16: Leistungshalbleiter
- 17: Diode
- 18: Energiespeicher
- 31: Tellerfederelement
- 32: oberer Innenrand
- 33: unterer Außenrand

## Patentansprüche

1. Spannverband (1) mit einer Anordnung (2) mechanisch verspannter, stapelweise übereinander liegender Bauelemente (3 - 9) mit einer Federeinrichtung sowie einer Spannvorrichtung zum Erzeugen mechanischer Drucckraft auf die Anordnung (2) der Bauelemente (3 -9), wobei die Federeinrichtung eine von einer Vielzahl von nebeneinander angeordneten und miteinander verbundenen Tellerfederelementen (31) gebildete Federplatte (3) ist, **dadurch gekennzeichnet, dass** die Tellerfederelemente (31) unterschiedliche Federcharakteristiken aufweisen, die Tellerfederelemente (31) einen oberen Innenrand (32) sowie einen unteren Außenrand (33)aufweisen und die Tellerfederelemente (31) an ihren unteren Außenrändern (33) miteinander verbunden sind um die Federplatte (3) zu bilden.

2. Spannverband (1) nach Anspruch 1, wobei ein Druckstück (11) zum Übertragen der mechanischen Druckkraft von der Spannvorrichtung auf die Anordnung (2) vorgesehen und die Federplatte (3) zwischen dem Druckstück (11) und den Bauelementen (3 -9) angeordnet ist.

3. Spannverband (1) nach einem der vorangehenden Ansprüche, wobei wenigstens eines der Tellerfederelemente (31) eine degressive Federcharakteristik aufweist.

4. Spannverband (1) nach einem der vorangehenden Ansprüche, wobei die Anordnung (2) eine weitere Federplatte (7) umfasst, die zwischen zwei Bauelementen (6, 8) angeordnet ist.

5. Spannverband (1) nach einem der vorangehenden Ansprüche, wobei die Anordnung (2) ein Halbleiterelement (5, 9) mit parallel angeordneten Press-Pack-Halbleitern umfasst.

6. Spannverband (1) nach Anspruch 5, wobei die Anordnung (2) wenigstens eine Kühlplatte (4, 6, 8) aus leitfähigem Material umfasst, wobei die wenigstens eine Kühlplatte (4, 6, 8) am Halbleiterelement (5, 9) anliegend angeordnet ist, so dass ein elektrischer Kontakt zwischen dem Halbleiterelement (5, 9) und der Kühlplatte (4, 6, 8) besteht.

7. Spannverband (1) nach Anspruch 6, wobei die Anordnung (2) eine Mehrzahl von Halbleiterelementen (5, 9) umfasst, wobei jedem Halbleiterelement (5, 9) wenigstens eine Kühlplatte (4, 6, 8) zugeordnet ist und die Halbleiterelemente (5, 9) eine elektrische Reihenschaltung ausbilden.

8. Spannverband (1) nach Anspruch 7, wobei jedem Halbleiterelement (5, 9) zwei Kühlplatten (4, 6, 8) zugeordnet sind, die beidseitig des Halbleiterelementes (5, 9) angeordnet sind.

9. Spannverband (1) nach Anspruch 8, wobei die Anordnung eine zusätzliche Federplatte (7) umfasst, die zwischen zwei Kühlplatten angeordnet ist.

10. Spannverband (1) nach Anspruch 9, wobei ferner ein dem Druckstück (11) gegenüberliegend angeordnetes Gegendruckstück vorgesehen ist, wobei eine ergänzende Federplatte zwischen dem Gegendruckstück und den Bauelementen angeordnet ist.

11. Spannverband (1) nach Anspruch 1, mit einem Submodul (12) eines Umrichters mit wenigstens einer Reihenschaltung von Leistungshalbleiterschalteinheiten (15), die jeweils einen ein- und abschaltbaren Leistungshalbleiter (16) mit gleicher Durchlassrichtung aufweisen und jeweils entgegen der besagten Durchlassrichtung leitfähig sind und einem dazu in einer Parallelschaltung angeordneten Energiespeicher (18),
**dadurch gekennzeichnet, dass** die Reihenschaltung der Leistungshalbleiterschalteinheiten (15) als Bauelement (3 - 9) in dem Spannverband (1) realisiert ist.

## Claims

1. Clamping assembly (1) having an arrangement (2) of mechanically clamped components (3 - 9) that lie one on top of the other so as to form a stack, said clamping assembly comprising a spring system and a clamping device for generating a mechanical compressive force onto the arrangement (2) of the components (3 - 9),
wherein
the spring system is a spring plate (3) that is formed by a multiplicity of mutually connected plate spring elements (31) that are arranged adjacent one to the other **characterized in that**
the plate spring elements (31) comprise different spring characteristics, the plate spring elements (31) comprise an upper inner edge (32) and a lower outer edge (33), and the plate spring elements (31) are connected one to the other at their lower outer edges (33) so that they form the spring plate (3) .

2. Clamping assembly (1) according to Claim 1, wherein a pressure piece (11) is provided for transmitting the mechanical compressive force from the clamping device to the arrangement (2) and the spring plate (3) is arranged between the pressure piece (11) and the components (3-9).

3. Clamping assembly (1) according to either of the preceding claims, wherein at least one of the plate spring elements (31) comprises a degressive spring characteristic.

4. Clamping assembly (1) according to any one of the preceding claims, wherein the arrangement (2) comprises a further spring plate (7) that is arranged between two components (6, 8).

5. Clamping assembly (1) according to any one of the preceding claims, wherein the arrangement (2) comprises a semi-conductor element (5, 9) having press pack semi-conductors that are arranged in parallel.

6. Clamping assembly (1) according to Claim 5, wherein the arrangement (2) comprises at least one cooling plate (4, 6, 8) that is embodied from a conductive material, wherein the at least one cooling plate (4, 6, 8) is arranged lying on the semi-conductor element (5, 9) so that an electrical contact is produced between the semi-conductor element (5, 9) and the cooling plate (4, 6, 8).

7. Clamping assembly (1) according to Claim 6, wherein the arrangement (2) comprises a plurality of semi-conductor elements (5, 9), wherein each semi-conductor element (5, 9) is allocated at least one cooling plate (4, 6, 8) and the semi-conductor elements (5, 9) form an electrical series connection.

8. Clamping assembly (1) according to Claim 7, wherein each semi-conductor element (5, 9) is allocated two cooling plates (4, 6, 8) that are arranged on both sides of the semi-conductor element (5, 9).

9. Clamping assembly (1) according to Claim 8, wherein the arrangement comprises an additional spring plate (7) that is arranged between two cooling plates.

10. Clamping assembly (1) according to Claim 9, wherein moreover a counter pressure piece is provided and arranged lying opposite the pressure piece (11), wherein an additional spring plate is arranged between the counter pressure piece and the components.

11. Clamping assembly (1) according to Claim 1, having a submodule (12) of a converter having at least one series connection of power semi-conductor switching units (15) that comprise in each case a power semi-conductor (16) that can be switched on and off with an identical through-flow direction and said power semi-conductor switching units are in each case conductive in the opposite direction to the said through-flow direction and said converter having an energy storage device (18) that is arranged in a parallel connection thereto, **characterized in that**
the series connection of the power semi-conductor units (15) is achieved as component (3 - 9) in the clamping assembly (1).

## Revendications

1. Assemblage (1) de serrage ayant un agencement (2) de composants (3 à 9) serrés mécaniquement et les uns sur les autres en pile, comprenant un dispositif à ressort, ainsi qu'un système de serrage pour produire une force de pression mécanique sur l'agencement (2) des composants (3 à 9),
dans lequel
le dispositif à ressort est une plaque (3) à ressort formée d'une pluralité d'éléments (31) de ressort à disque disposés les uns à côté des autres et reliés entre eux,
**caractérisé en ce que** les éléments (3) de ressort à disque ont des caractéristiques de ressort différentes, les éléments (31) de ressort à disque ont un bord (32) intérieur supérieur, ainsi qu'un bord (33) extérieur inférieur, et les éléments (31) de ressort à disque sont reliés entre eux à leurs bords (33) extérieurs inférieurs pour former la plaque (3) à ressort.

2. Assemblage (1) de serrage suivant la revendication 1, dans lequel il est prévu une pièce (11) d'application d'une pression pour transmettre la force de pression mécanique du système de serrage à l'agencement (2) et la plaque (3) à ressort est disposée entre la pièce (11) d'application d'une pression et les composants (3 à 9).

3. Assemblage (1) de serrage suivant l'une des revendications précédentes, dans lequel au moins l'un des éléments (31) de ressort à disque a une caractéristique de ressort dégressive.

4. Assemblage (1) de serrage suivant l'une des revendications précédentes, dans lequel l'assemblage (2) comprend une autre plaque (7) à ressort disposée entre deux composants (6, 8).

5. Assemblage (1) de serrage suivant l'une des revendications précédentes, dans lequel l'agencement (2) comprend un élément (5, 9) à semi-conducteur ayant des semi-conducteurs press-pack montés en parallèle.

6. Assemblage (1) de serrage suivant la revendication 5, dans lequel l'agencement (2) comprend au moins une plaque (4, 6, 8) de refroidissement en matériau conducteur, la au moins une plaque (4, 6, 8) de refroidissement s'appliquant à l'élément (5, 9) à semi-conducteur de manière à constituer un contact électrique entre l'élément (5, 9) à semi-conducteur et la plaque (4, 6, 8) de refroidissement.

7. Assemblage (1) de serrage suivant la revendication 6, dans lequel l'agencement (2) comprend une pluralité d'éléments (5, 9) à semi-conducteur, au moins une plaque (4, 6, 8) de refroidissement étant associée à chaque élément (5, 9) à semi-conducteur et les éléments (5, 9) à semi-conducteur constituant un circuit électrique en série.

8. Assemblage (1) de serrage suivant la revendication 7, dans lequel, à chaque élément (5, 9) à semi-conducteur, sont associées deux plaques (4, 6, 8) de refroidissement disposées de part et d'autre de l'élément (5, 9) à semi-conducteur.

9. Assemblage (1) de serrage suivant la revendication 8, dans lequel l'agencement comprend une plaque (7) à ressort supplémentaire disposée entre deux plaques de refroidissement.

10. Assemblage (1) de serrage suivant la revendication 9, dans lequel il est prévu, en outre, une pièce de contrepression disposée en opposition à la pièce (11) d'application d'une pression, une plaque à ressort complémentaire étant disposée entre la pièce de contrepression et les composants.

11. Assemblage (1) de serrage suivant la revendication 1, comprenant un sous-module (12) d'un convertisseur, ayant au moins un montage en série d'unités (15) d'interruption à semi-conducteur de puissance, qui ont chacune un semi-conducteur (16) de puissance pouvant être passant et bloqué, en ayant le même sens passant, et qui chacune sont conductrices dans le sens contraire audit sens passant, et un accumulateur (18) d'énergie, monté dans un montage en parallèle,
**caractérisé en ce que**
le montage en série des unités (15) d'interruption à semi-conducteur de puissance est réalisé sous la forme d'un composant (3 à 9) de l'assemblage (1) de serrage.
